# FASCICULE DE BREVET EUROPEEN

(11) **EP 2 185 943 B1**
(45) Date de publication et mention de la délivrance du brevet: **02.11.2011**
(21) Numéro de dépôt: 08836167.0
(22) Date de dépôt: 05.09.2008
(51) Int. Cl.: G01R 31/28, G01R 31/02, G01R 31/311, G01R 31/30

(54) **PROCEDE DE CARACTERISATION DE LA SENSIBILITE AUX INTERACTIONS ENERGETIQUES D'UN COMPOSANT ELECTRONIQUE**
VERFAHREN ZUR CHARAKTERISIERUNG DER EMPFINDLICHKEIT EINER ELEKTRONISCHEN KOMPONENTE BEZÜGLICH ENERGETISCHER WECHSELWIRKUNGEN
METHOD FOR CHARACTERISING THE SENSITIVITY OF AN ELECTRONIC COMPONENT TO ENERGETIC INTERACTIONS

(30) Priorité: 06.09.2007 FR 0757389
(43) Date de publication de la demande: 19.05.2010
(73) Titulaire: European Aeronautic Defence and Space Company EADS France, 75781 Paris Cedex 16 (FR)
(72) Inventeur: BUARD, Nadine, F-92190 Meudon (FR); MILLER, Florent, F-75005 Paris (FR); HEINS, Patrick, F-81140 Castelnau de Montmiral (FR); CARRIERE, Thierry, F-78510 Triel sur Seine (FR)
(74) Mandataire: Lotaut, Yacine Diaw
(86) Numéro de dépôt international: PCT/FR2008/051593
(87) Numéro de publication internationale: WO 2009/044058

(56) Documents cités:
- WO-A-02/35249
- GB-A- 2 069 152
- US-A- 4 786 865
- US-A1- 2003 001 597
- US-B1- 7 019 311

## Description

La présente invention a pour objet un procédé de caractérisation de la sensibilité aux interactions énergétiques dans un composant électronique qui permet de déterminer les conditions d'utilisation préférables de ce composant

Le fonctionnement des composants électroniques peut être perturbé par l'environnement dans lequel ils évoluent, par exemple l'environnement radiatif naturel ou artificiel ou l'environnement électromagnétique. Des agressions extérieures provoquent la création de courants parasites par interaction avec la matière constitutive du composant. Ces derniers peuvent être à l'origine du dysfonctionnement transitoire ou permanent du composant et de l'application qui l'utilise.

Pour l'environnement radiatif naturel, ces effets dénommés de façon générique effets singuliers sont créés par des particules. Par exemple, des ions lourds et protons dans l'espace, affectent les équipements électroniques des satellites et des lanceurs. A des altitudes moins élevées où évoluent des avions, on note surtout la présence de neutrons qui créent également des effets singuliers. Sur le sol terrestre, de telles agressions peuvent aussi être rencontrées et affecter les composants électroniques, qu'elles soient dues aux particules de l'environnement naturel, aux particules radioactives présentes dans les boîtiers, ou à des problèmes d'immunité, d'intégrité de signal, ou d'instabilités thermiques ou de procédé. Dans la suite du texte, les effets des particules seront plus particulièrement considérés, mais l'invention reste applicable aux mêmes types d'effets créés par des environnements divers et variés.

Les phénomènes physiques à l'origine des défaillances provoquées par les agressions extérieures sont très variés. Il est possible néanmoins d'identifier plusieurs grandes familles de défaillance. L'invention s'applique plus particulièrement à une partie des effets provoqués par les environnements radiatifs ou électromagnétiques qui se produisent par l'action couplée d'une création de courants parasites et de phénomènes d'amplification et ou d'entretien de ces courants parasites.

On peut citer à titre d'exemple, un déclenchement d'un thyristor parasite, dit latchup ou Single Event Latchup ou SEL, global ou localisé dans une partie du composant (on parle alors de microlatchup), un déclenchement d'un transistor bipolaire parasite, dit snapback ou SES, une défaillance mettant en jeu l'action couplée du déclenchement d'une structure bipolaire parasite et d'un phénomène d'amplification et ou d'entretien du courant parasite dit Single Event Burnout ou SEB. Ces effets peuvent être ou non destructifs pour le composant.

US 4 786 865 (Arimura et al.) et GB2069152 (The Post Office) divulguent des test de sensibilité aux interactions énergetiques telles que SEL. De manière plus précise, l'interaction d'une particule ou d'un rayonnement avec la matière peut résulter en la création de charges électrons et trous. Sous certaines conditions, ces charges peuvent provoquer le déclenchement d'une ou plusieurs structures parasites. Ces structures sont qualifiées de parasites car, bien qu'existant de façon intrinsèque dans le composant, elles ne sont jamais activées lorsque le composant est dans un régime de fonctionnement normal.

Les conditions pour que ces déclenchements se produisent sont principalement liées à la quantité de charge générée, à la localisation et à la forme (spatiale et temporelle) de cette génération de charge.

Cependant, la plupart du temps, le déclenchement de ces seules structures parasites, conséquence de la génération de charges, ne suffit pas à provoquer la défaillance du composant. Un deuxième phénomène permet d'entretenir et ou d'amplifier le courant parasite généré par le premier phénomène. Le déclenchement de ce deuxième phénomène est principalement lié aux caractéristiques intrinsèques du composant (niveau de dopage, organisation physique du composant, ...) et aux conditions d'utilisation du composant, notamment de polarisation, de fréquence, de température, .....

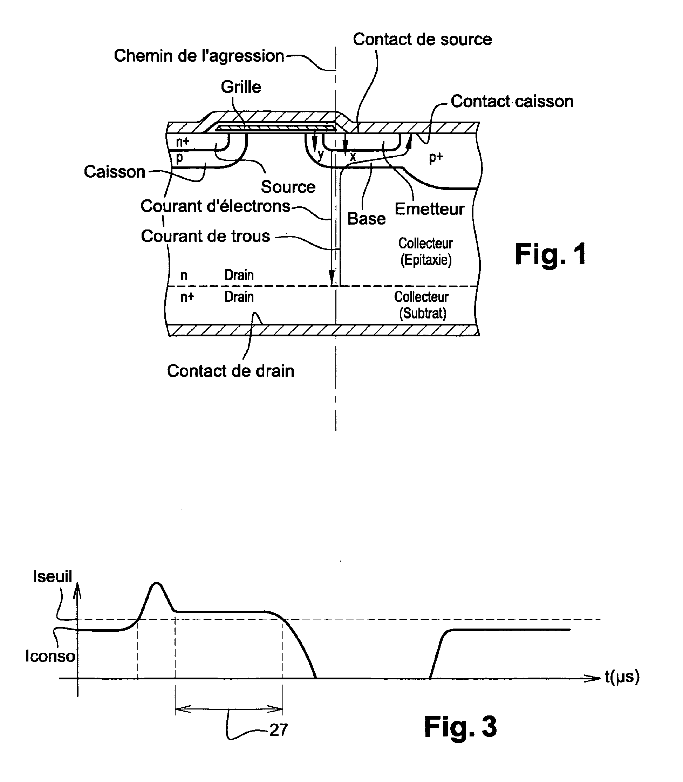

A titre d'exemple, un phénomène SEB peut ainsi être déclenché dans des composants de puissance. Ceux-ci sont par exemple des transistors MOS de puissance à effet de champ, MOSFET, des transistors bipolaires à grille isolée, IGBT, de l'anglais Insulated Gate Bipolar Transistor, des diodes de puissance ou autres. A titre d'exemple, la figure 1 montre, pour un tel transistor MOSFET de puissance, de type N, en technologie silicium, polarisé (tension drain-source positive) et initialement à l'état bloqué, et avec une structure bipolaire parasite, que l'interaction (directe ou indirecte) d'une particule de l'environnement radiatif naturel avec le silicium constitutif de ce transistor se traduit par la création d'un certain nombre de paires électrons trous dans le composant. Sous l'influence des champs électriques et des phénomènes de diffusion, ces charges se déplacent, ce qui génère un courant parasite au sein de la structure. Sous certaines conditions, notamment de localisation de la génération de charges et de quantité de charges générées, le courant parasite peut provoquer le passage en direct d'une jonction source-caisson initialement bloquée. Dans la mesure où cette jonction source-caisson devient passante, alors que la jonction caisson-drain est polarisée en inverse, un transistor bipolaire parasite, source-caisson-drain est déclenché. La source en est l'émetteur, le caisson en est la base et le drain, le collecteur. En l'absence de phénomène d'amplification et ou d'entretien, cette structure parasite reste passante tant que les charges générées par l'interaction particule-silicium ne sont pas encore toutes évacuées. Ensuite, elle est de nouveau bloquée et le composant retrouve son fonctionnement nominal. Néanmoins, en fonction de certains paramètres, notamment de la tension de polarisation appliquée au drain, de la température et de la technologie interne du composant, les conditions peuvent être réunies pour qu'un phénomène d'ionisation par impact localisé initialement à la jonction caisson-drain (fortement polarisée en inverse) se produise et permette l'amplification et l'entretien du courant parasite de la structure bipolaire parasite source-caisson-drain. L'amplification du courant parasite provoque, en général en l'absence de protection, la destruction du composant.

Cet exemple montre que le phénomène SEB se déclenche bien par l'action couplée de deux phénomènes: le déclenchement d'une structure parasite et l'amplification-entretien du courant parasite.

La nature physique du phénomène d'amplification et ou d'entretien du courant parasite initial varie suivant les types d'effets des radiations et les types de composants. Dans le cas du phénomène SEB, il s'agit d'une amplification-entretien de courant due à l'ionisation par impact. Dans le cas du phénomène SEL, pour les technologies CMOS, l'amplification-entretien de courant se fait par déclenchement d'une structure bipolaire parasite couplée à la première, et les conséquences sont ou transitoires, ou permanentes ou destructives.

Actuellement, il n'existe pas de dispositif permettant de mesurer la tension de polarisation, ou autres caractéristiques d'utilisation, fréquence, température, pression, valeur de champ magnétique, ou autres, en dessous desquelles un composant ne peut plus être sujet à de tels déclenchement parasites.

L'objet de l'invention est de remédier à ce problème en proposant d'utiliser un système basé sur un laser, de préférence pulsé, permettant de mettre en évidence, d'une part si un composant électronique est intrinsèquement sensible aux défaillances mettant en jeu des phénomènes de création de courants parasites ainsi que d'amplification et ou entretien, et d'autre part d'identifier et de quantifier la sensibilité de ce composant à ces mêmes effets lorsque les conditions d'utilisation du composant sont modifiées. En ce sens, l'invention permet de définir les bonnes conditions d'utilisation. Ces bonnes conditions d'utilisation si elles sont respectées minimisent la probabilité d'apparition de telles défaillances en cas d'interactions énergétiques, en particulier celles dues à l'environnement radiatif naturel.

Si ses propriétés sont bien choisies, un laser permet, à l'instar des particules, d'ioniser localement et de façon transitoire le semi-conducteur constituant des composants électroniques, induisant par conséquence des courants parasites. Pour cela, le laser doit posséder une longueur d'onde permettant la génération de charges (par phénomène d'absorption linéaire ou non linéaire) dans le matériau constitutif du composant. Par exemple, dans le cas de l'absorption linéaire dans le silicium, la longueur d'onde du laser doit être inférieure à 1.1µm (l'énergie du photon laser de la source laser est supérieure à la valeur de la bande interdite du composant semi-conducteur). Le laser est utilisé préférentiellement en mono impulsion ou synchronisé par rapport à un signal du composant sous test. Un système d'optique est utilisé pour focaliser le rayonnement laser au niveau des zones actives du composant. Enfin, il existe sur le chemin optique du faisceau laser un système permettant de modifier l'énergie du laser. Ce système possède une interface qui permet son pilotage depuis un ordinateur.

Un système de moteurs permet le déplacement relatif du faisceau laser par rapport au composant électronique selon les trois axes de l'espace.

Le boîtier du composant électronique testé est de préférence ouvert sur l'une de ses deux faces de manière à permettre au faisceau laser d'exciter les zones de sensibilité. De préférence, cette ouverture est pratiquée sur la face arrière du composant.

Le composant testé est placé dans un environnement qui recrée ses conditions d'utilisation, notamment, sa fréquence de fonctionnement, sa polarisation, sa température et le composant réalise, s'il y a lieu, la fonction qui lui a été assignée. Un système de test permet de détecter la défaillance et le cas échéant de la désamorcer pour éviter la perte définitive de fonctionnalité du composant.

L'invention a donc pour objet un procédé de caractérisation de la sensibilité aux interactions énergétiques dans un composant électronique dans lequel,
- on met le composant électronique en service,
- on excite le composant électronique ainsi mis en service à l'aide d'un rayonnement laser,
- on mesure un défaut de fonctionnement du composant électronique mis en service correspondant à une valeur de cette excitation,
   **caractérisé en ce que**
- on change des conditions d'utilisation du composant, à savoir de polarisation, et ou de signaux d'entrée et ou de signaux de commande et ou de fréquence et ou de température, et ou de charge en sortie
- on mesure à titre de caractéristique des conditions changées d'utilisation pour lesquelles le composant laisse apparaître ou non un tel phénomène de déclenchement.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
Figure 1 : déjà commentée, un phénomène SEB déclenché dans des composants de puissance;
Figure 2: un dispositif utilisable pour mettre en oeuvre le procédé de l'invention;
Figure 3: la description d'un système permettant l'identification et le désamorçage pour un phénomène SEL;
Figure 4: la description d'un système permettant l'identification et le désamorçage pour un phénomène SEB;
Figure 5 : une cartographie de sensibilité au SEB d'un transistor MOS de puissance en fonction de la tension de polarisation drain-source;
Figure 6 : une évolution de l'amplitude maximale de courant, pour une énergie laser donnée, en fonction de la tension de polarisation drain-source.

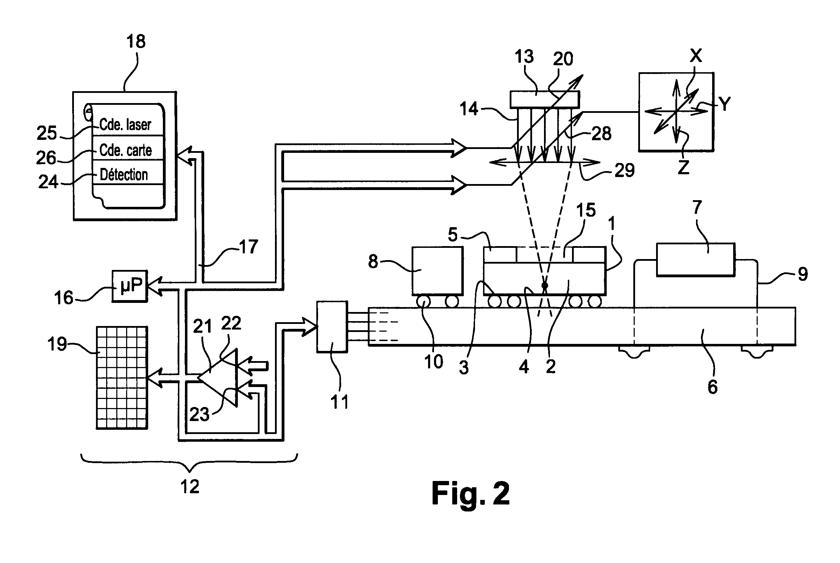

La figure 2 montre un dispositif utilisable pour mettre en oeuvre le procédé de l'invention. Le but de l'invention est de mesurer les effets d'interactions énergétiques dans un composant électronique 1, par exemple du type de celui de la figure 1. Le composant électronique 1 comporte ainsi, d'une manière connue, et présenté à l'envers, un cristal semi-conducteur 2 dans lequel sont réalisées diverses implantations : des caissons et des zones implantées par des impuretés, voire des zones épitaxiées. Des connexions, typiquement métalliques, telles que 3 débouchent sur une interface 4 de connexion du composant électronique 1. .Il existe parfois, un support et/ou une protection 5 situées sur les faces supérieures et/ou inférieures du cristal 2.

Dans l'invention, pour mesurer les défauts de fonctionnement d'un composant électronique 1 qui serait soumis à des interactions énergétiques, on monte ce composant 1 sur une carte électronique de test 6 de type circuit imprimé, monocouche ou multicouches. La carte 6 peut comporter à cet égard d'autres composants tels que 7 et 8, du type à broches 9 de connexion traversant la carte 6, ou du type à boules de soudure telles que 10 pour composants montés en surface. Ces autres composants peuvent servir à modifier les conditions de fonctionnement du composant 1. Par exemple le composant 7 peut être une résistance de chauffage thermostatée pour porter le composant 1 à une température voulue. Par exemple, le composant 8 peut être une horloge à fréquence pilotée pour commander le composant 1 avec une fréquence voulue. Ces autres composants peuvent aussi servir à la protection du composant 1.

La carte 6 possède un connecteur 11 pour être reliée à un appareil 12 de test pour mesurer la sensibilité du composant 1 aux particules énergétiques. Avec cet appareil 12, on excite le composant 1 au moyen d'une source laser 13. Cette source laser 13 émet un rayonnement 14 qui vient agresser le composant électronique 1. De manière à favoriser cette agression, de préférence, le composant 1 est soumis à cette agression par sa base 5. De manière à favoriser cette agression, de préférence le support et ou la protection 5 est ouverte (notamment par processus chimique ou mécanique) dans une fenêtre 15 par laquelle peut pénétrer le rayonnement 14 du laser 13. Dans un exemple la source laser provoque une absorption simultanée de plusieurs photons dans le matériau semi conducteur.

Au moment du test, le composant électronique 1 est relié par son interface 11 au dispositif 12 qui peut pourvoir à son alimentation et à sa commande. Le dispositif 12 comporte, d'une manière schématique, un microprocesseur 16 relié par un bus 17 de commandes, d'adresses et de données à une mémoire programme 18, à une mémoire de données 19, à l'interface 11, à la source laser 13 et à un système 20 d'atténuation de l'énergie laser. Le dispositif 12 comporte par ailleurs, schématiquement représenté, un comparateur 21 recevant d'une part sur une entrée de consigne 22 une grandeur électrique attendue et sur une entrée de mesure 23 des signaux électriques prélevés par l'interface 11 dans le composant 1, alors que ce dernier subit les interactions et les excitations du laser 13.

Le comparateur 21 peut pour sa part être remplacé par un sous-programme 24 de mesure du signal reçu du composant électronique 1. Le fonctionnement de la mesure peut être statique : on teste dans ce cas uniquement des valeurs de potentiels et de courants disponibles sur des plots de l'interface 11. Il peut être dynamique. Le microprocesseur 16 comporte en outre une horloge qui égrène certaines opérations dont le déroulement doit subir un historique connu, par exemple une croissance ou une décroissance de l'énergie laser. On mesure si une réponse à cet historique se produit de manière attendue ou si elle présente des anomalies.

La mémoire programme 18 comporte dans ce but un programme 25 de commande de la source laser 13, de ses déplacements XYZ par rapport au composant 1 et de sa puissance. La mémoire 18 comporte enfin de préférence un programme 26 de changement de mode de fonctionnement du composant 1. De tels changements visent la fréquence de l'horloge 8, les signaux d'entrée et ou de commande, la charge en sortie, la ou les tensions de polarisation du composant 1 disponibles par ailleurs sur le bus 17 et à l'interface 11, et la température imposée par exemple par le radiateur 7. Si d'autres conditions de fonctionnement sont envisagées, la carte 6 peut comporter les composants, notamment magnétiques qui les provoquent. Ces autres composants sont aussi pilotés par le microprocesseur 16.

Dans l'exemple de la figure 3, le système de test surveille la consommation de courant Iconso du composant 1. Lorsqu'une surconsommation est détectée, Iconso supérieur à un seuil Iseuil, le courant est limité, pour éviter la destruction du composant, et maintenu pendant un certain temps 27, de manière à s'assurer qu'il s'agit bien d'un phénomène de SEL, puis l'alimentation est coupée et enfin le composant 1 est remis sous tension. Le phénomène de SEL a ainsi été détecté puis désamorcé afin de ne pas détruire le composant 1.

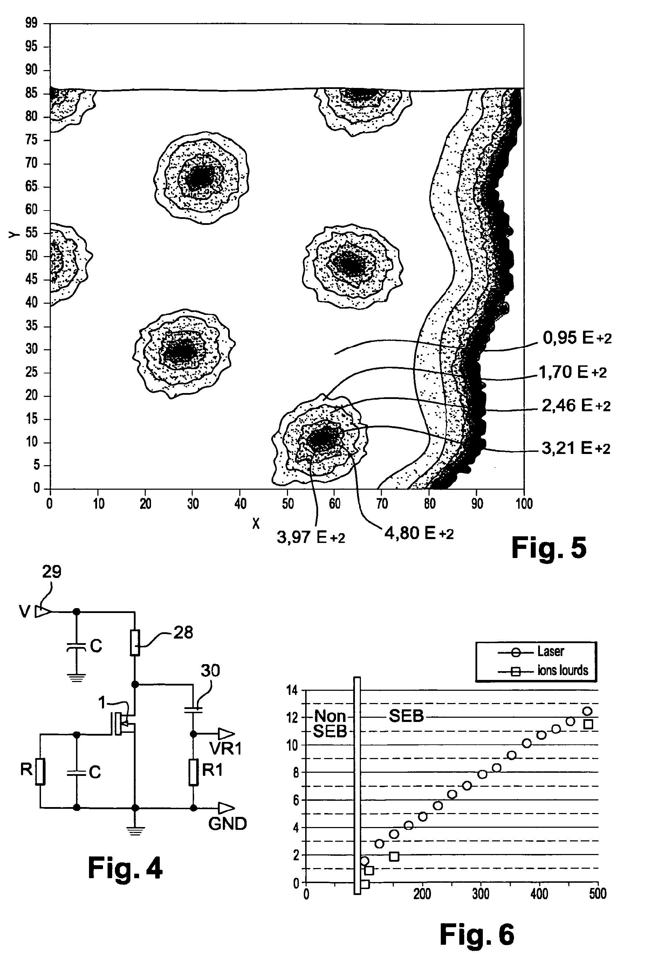

Dans un exemple, la carte 6 est munie des composants montrés sur le schéma de la figure 4. Dans le même but de protection, une résistance 28, placée en série sur l'alimentation 29 du composant 1 permet de limiter le courant délivré. Lorsqu'un phénomène de SEB se déclenche, un transistor du composant 1 devient transitoirement passant. Le courant ne pouvant être fourni par l'alimentation 29 (du fait de la résistance 28), une capacité 30 en parallèle sur le composant 1 se décharge. Cette décharge produit la durée 27. Lorsque la capacité 30 est totalement déchargée, le courant nécessaire au maintien de la défaillance n'est plus fourni. Le composant 1 retourne alors dans son état nominal. La défaillance a été désamorcée. Ce système permet donc d'observer la défaillance, en mesurant par exemple avec un oscilloscope la décharge de la capacité, mais aussi d'éviter que cette défaillance ne soit destructive.

Les tirs laser sont synchronisés ou non par rapport à un signal du composant sous test, et pour chaque tir, une vérification est effectuée sur le système de test pour voir si une ou plusieurs défaillances ont eu lieu.

Pour une position d'intérêt en X et Y, la focalisation du faisceau laser est ajustée de manière à identifier la position pour laquelle le composant présente une sensibilité maximale vis-à-vis d'une impulsion laser. Cette sensibilité maximale est obtenue lorsque l'énergie laser nécessaire pour provoquer la défaillance est minimale. Cette opération est effectuée pour une position d'intérêt et des conditions d'utilisation données mais peut également être répétée de manière systématique sur toutes les positions de la cartographie laser. Par ailleurs, une focalisation optimale en profondeur Z est déterminée, ou bien une cartographie de sensibilité en 3 dimensions est réalisée.

Les positions et instants des tirs laser peuvent être choisis aléatoirement pour reproduire l'impact de particules de l'environnement radiatif naturel ou non, ou bien au contraire soigneusement ajustés afin de localiser les positions spatiales et temporelles mettant en défaillance le composant.

Ensuite, pour une énergie laser supérieure à cette énergie minimale, pour les différentes positions, l'un des paramètres de condition d'utilisation du composant est ajusté de manière à détecter le seuil de ce paramètre au-delà duquel la défaillance se déclenche. Pour cette condition d'utilisation, le domaine de fonctionnement préférable du composant vis-à-vis des interactions énergétiques est ainsi déterminé.

Une cartographie spatiale de sensibilité du composant peut donc être réalisée en fonction des conditions d'utilisation du composant aussi bien qu'en fonction de l'énergie laser.

La figure 5 présente à cet égard un exemple de l'influence de la tension de polarisation drain-source sur le déclenchement du phénomène SEB dans un composant de puissance. Elle montre que si la tension de polarisation est inférieure à 95 Volts (0,95 E+2), le composant 1 résiste aux agressions en tous points: le phénomène de SEB ne se produit pas. Elle révèle aussi que, par endroits très localisés en quelques taches visibles, l'agression laser ne produit un phénomène SEB que si la tension de polarisation est supérieure à 480 Volts.

Pour une position de la cartographie de la figure 5, la courbe de la figure 6 peut être extraite. Elle présente par exemple pour une énergie laser donnée, l'évolution de l'amplitude de courant maximale en fonction de la tension de polarisation drain-source. Deux zones sont identifiées. Au-delà de 95Volts, le composant est sensible à la défaillance. En dessous de 95Volts, la défaillance ne se déclenche pas pour cette position. Elle montre également le caractère justifié de l'approximation laser en comparant les agressions laser (courbe avec les petits ronds) et les agressions aux ions lourds (courbe avec les petits carrés) donnant un même résultat en terme de seuil au delà duquel un phénomène SEB se produit ou non, et valide ainsi la méthode vis-à-vis de l'environnement considéré.

## Revendications

1. - Procédé de caractérisation de la sensibilité aux interactions énergétiques dans un composant (1) électronique dans lequel,
- on met (6, 11,19) le composant électronique en service,
- on excite (12) le composant électronique ainsi mis en service à l'aide (13) d'un rayonnement (14) laser,
- on mesure (24) un défaut de fonctionnement du composant électronique mis en service correspondant à une valeur de cette excitation, **caractérisé en ce que**
- on change (26) des conditions d'utilisation du composant, autrement dit, de polarisation drain-source du composant, et ou de signaux d'entrée et ou de signaux de commande et ou de fréquence et ou de température, et ou de charge en sortie,
- on mesure (Fig. 6), à titre de caractéristique, des conditions changées d'utilisation pour lesquelles le composant laisse apparaître ou non un défaut de fonctionnement par un phénomène de déclenchement.

2. - Procédé selon la revendication 1, **caractérisé en ce que**
- une limite de la condition ainsi changée représente une condition limite dans le cas d'interactions énergétiques.

3. - Procédé selon l'une des revendications 1 à 2, **caractérisé en ce que**
- les phénomènes de déclenchement étudiés sont ceux du SEB ou du SEL ou du microlatchup ou du SES ou tout autre phénomène mettant en jeu le déclenchement d'une structure bipolaire parasite couplée à un mécanisme d'entretien et /ou d'amplification du courant.

4. - Procédé selon l'une des revendications 1 à 3, **caractérisé en ce que**
- on ouvre une fenêtre (15) dans un support ou une protection (5) de la dalle du composant,
- on excite le composant par une face de la dalle (2) de ce composant.

5. - Procédé selon l'une des revendications 1 à 4, **caractérisé en ce que**
- on focalise le rayonnement laser à différentes profondeurs dans le composant, de préférence pour une localisation d'intérêt.

6. - Procédé selon l'une des revendications 1 à 5, **caractérisé en ce que**
- on protège (28, 30) le composant pendant cette excitation,
- de préférence la protection comporte la mise en place d'un circuit de protection dans un circuit de polarisation du composant.

7. - Procédé selon l'une des revendications 1 à 6, **caractérisé en ce que**
- on établit une carte (Fig 5) de localisations d'intérêt dans le composant où ces interactions sont les plus fortes.

8. - Procédé selon l'une des revendications 1 à 7, **caractérisé en ce que**
- on fait varier, de préférence par pas, une puissance du laser.

9. - Procédé selon l'une des revendications 1 à 8, **caractérisé en ce que**
- l'énergie du photon laser de la source laser est supérieure à la valeur de la bande interdite du composant semi-conducteur.

10. - Procédé selon l'une des revendications 1 à 9, **caractérisé en ce que**
- pour une position d'intérêt, la focalisation du faisceau laser est ajustée à une valeur d'énergie minimale de manière à identifier la position pour laquelle le composant présente une sensibilité maximale vis-à-vis d'une impulsion laser,
- pour une énergie laser supérieure à cette énergie minimale, on modifie un des paramètres de condition d'utilisation du composant de manière à détecter le seuil de ce paramètre au-delà duquel la défaillance se déclenche.

## Claims

1. - A method for characterizing the sensitivity to energetic interactions in an electronic component (1) in which,
- the electronic component is turned on (6, 11, 19),
- the electronic component, which is thus turned on, is excited (12) and thus turned on using (13) laser radiation (14),
- an operational failure is detected (24) in the electronic component, that is turned on, corresponding to a value of excitation,
**characterized in that**
- the component's use conditions change (26), in other words, the component's drain/source polarization and/or input signal and/or command signal and/or frequency and/or temperature and/or output charge
- as a characteristic, the changed use conditions are measured (Fig. 6), which may or may not reveal the failed operation due to a triggering phenomenon.

2. - A method according to claim 1, **characterized in that**
- a limit of the thus changed condition represents a limiting condition for energetic interactions.

3. - A method according to any one of claims 1 to 2, **characterized in that**
- the triggering phenomena studies are SEB, SEL, microlatchup, SES, or any other phenomena involving a parasitic bipolar structure combined with a current amplification and/or maintenance mechanism.

4. - A method according to any one of claims 1 to 3, **characterized in that**
- a window (15) is opened in a support or protector (5) for the base of the component,
- the component is excited by a face of its base (2).

5. - A method according to any one of claims 1 to 4, **characterized in that**
- the laser radiation is focused at various depths in the component, preferably for a location of interest.

6. - A method according to any one of claims 1 to 5, **characterized in that**
- the component is protected (28, 30) during this excitation,
- the protection preferably comprises setting up protective circuit in a polarization circuit on the component.

7. - A method according to any one of claims 1 to 6, **characterized in that**
- a map (Fig. 5) is established with locations of interest in the component where these interactions are strongest.

8. - A method according to any one of claims 1 to 7, **characterized in that**
- the power of the laser can preferably be varied by steps.

9. - A method according to any one of claims 1 to 8, **characterized in that**
- the energy of the laser photon from the laser source is greater than the value of the semiconductor component's band gap.

10. - A method according to any one of claims 1 to 9, **characterized in that**
- for a position of interest, the focus of the laser beam is adjusted to a minimum energy value in order to identify the position at which the component demonstrates a maximum sensitivity to a laser pulse,
- for a laser energy greater than this minimum energy, one of the parameters in the component's use conditions is modified so as to detect the threshold for the parameter, beyond which a failure is triggered.

## Patentansprüche

1. - Verfahren zur Charakterisierung der Empfindlichkeit auf energetischen Wechselwirkungen in ein elektronisches Komponent (1) in welches,
- das elektronische Komponent betrieben wird (6,11,19),
- das elektronische Komponent , das so betrieben wurde , mittels (13) einer Laserstrahlung (14) angeregt wird (12),
- eine Fehlfunktion des betriebenen elektronischen Komponents einen Anregungswert entsprechend, gemessen wird (24),
**dadurch gekennzeichnet, dass**
- Einsatzbedingungen des Komponents geändert werden (26), d.h. die Drain-Source Polarisation des Komponents, und oder die Eingangssignalen und oder die Steuersignalen und oder die Frequenz und oder die Temperatur, und oder die Ausgangsbelastung,
- als Charakteristik, geänderte Einsatzbedingungen gemessen (Fig. 6) werden für welche, das Komponent eine Fehlfunktion durch einen Auslösevorgang anzeigt oder nicht anzeigt.

2. - Verfahren nach Anspruch 1, **dadurch gekennzeichnet, dass**
- eine somit geänderte Grenze der Bedingung im Falle energetischen Wechselwirkungen eine Grenzbedingung ist.

3. - Verfahren nach einem der Ansprüche 1 bis 2, **dadurch gekennzeichnet, dass**
- die untersuchten Auslösevorgänge, die vom SEB oder SEL oder Mikro-Latch-Up oder vom SES oder jeden anderen Vorgang sind, der die Auslösung einer zweipoligen Störstruktur einsetzt, die an eine Wartungsvorrichtung und/oder an eine Stromverstärkung gekoppelt ist.

4. - Verfahren nach einem der Ansprüche 1 bis 3, **dadurch gekennzeichnet, dass**
- ein Fenster (15) in einen Träger oder eine Schutz (5) der Platte des Komponentsgeöffnet wird,
- das Komponent durch eine Fläche der Platte (2) dieses Komponents angeregt wird.

5. - Verfahren nach einem der Ansprüche 1 bis 4, **dadurch gekennzeichnet, dass**
- der Laserstrahl in unterschiedlichen Tiefen im Komponent fokussiert wird, vorzugsweise für eine Interesse-Lokalisierung.

6. - Verfahren nach einem der Ansprüche 1 bis 5, **dadurch gekennzeichnet, dass**
- während dieser Anregung, das Komponent geschützt wird (28,30),
- vorzugsweise die Schutz die Einsetzung eines Schutzkreises in einen Polarisationskreis des Komponents aufweist.

7. - Verfahren nach einem der Ansprüche 1 bis 6, **dadurch gekennzeichnet, dass**
- eine Interesse-Lokalisierungskarte (Fig.5) im Komponent wo diese Wechselwirkungen am stärksten sind, erstellt wird.

8. - Verfahren nach einem der Ansprüche 1 bis 7, **dadurch gekennzeichnet, dass**
- eine Laserleistung, vorzugsweise pro Schritt variiert wird.

9. - Verfahren nach einem der Ansprüche 1 bis 8, **dadurch gekennzeichnet dass**
- die Energie des Photon-Lasers der Laserquelle grösser ist als der Wert der Bandlücke des Halbleiter-Komponents.

10. - Verfahren nach einem der Ansprüche 1 bis 9, **dadurch gekennzeichnet, dass**
- für eine Interesse-Position, die Fokussierung der Laserstrahlung an einen minimalen Energiewert angepasst ist, so dass die Position für welche das Komponent eine maximale Empfindlichkeit gegenüber einer Laserimpuls aufweist, identifiziert wird,
- für eine Laserenergie grösser als diese minimale Energie, eines der Parameter der Einsatzbedingungen des Komponents wird derart geändert, dass die Schwelle dieses Parameters, bei deren Überschreitung die Fehlfunktion eingestellt wird, erfasst wird.
